# EUROPEAN PATENT APPLICATION

(11) **EP 4 836 184 A1**
(43) Date of publication of application: **04.11.2026**
(21) Application number: 24913441.2
(22) Date of filing: 27.12.2024
(51) Int. Cl.: H01Q 1/02, H05K 7/20

(54) **ACTIVE HEAT DISSIPATION APPARATUS**

(30) Priority: 28.12.2023 KR 20230194406; 26.12.2024 KR 20240196502
(71) Applicant: KMW Inc., Hwaseong-si, Gyeonggi-do 18462 (KR)
(72) Inventor: JI, Kyo Sung, Hwaseong-si Gyeonggi-do 18484 (KR); SEO, Jin Kook, Busan 46726 (KR); YANG, Won Seok, Hwaseong-si Gyeonggi-do 18479 (KR); KANG, Seong Man, Hwaseong-si Gyeonggi-do 18430 (KR); YANG, Jun Woo, Suwon-si Gyeonggi-do 16694 (KR); KIM, Ji Hwan, Seoul 07809 (KR); CHOI, Ji Seong, Anyang-si Gyeonggi-do 14008 (KR); KIM, Han Gyeol, Yongin-si Gyeonggi-do 17085 (KR); KIM, Dong Hwan, Hwaseong-si Gyeonggi-do 18486 (KR); YOON, Gye Young, Seoul 04756 (KR); CHOI, In Hwa, Yongin-si Gyeonggi-do 17148 (KR)
(74) Representative: impuls legal PartG mbB
(86) International application number: PCT/KR2024/021212
(87) International publication number: WO 2025/143834

(57) **Abstract**

The present invention relates to an active heat dissipation apparatus comprising: a heat-conducting panel body having therein a refrigerant flow space in which a refrigerant is filled and flows; and a refrigerant damper which is disposed in the middle of the refrigerant flow space in the thickness direction and, when the refrigerant freezes and expands, elastically absorbs the expansion of the frozen refrigerant within a range that does not increase the separation distance between one side surface and the other side surface of the refrigerant flow space. Therefore, the present invention provides the advantage of making it possible to prevent product damage during extreme cold weather.

## Description

### [Technical Field]

The present disclosure relates to an active heat dissipation apparatus, and more particularly, to an active heat dissipation apparatus that can improve heat dissipation performance by actively transferring heat generated from a heat generating device (e.g., an electronic device) through a phase change of a refrigerant that is more effective than the inherent thermal conductivity of a material itself.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, and displays. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

However, a conventional cooling system has limitations in dissipating a high level of heat generated by continuously developing and advanced technologies. Thus, there is a need in related industrial fields for innovative technologies capable of solving these problems, and as part of efforts to solve them, heat dissipation apparatuses are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a material is referred to as sensible heat, whereas the heat used during a phase change is referred to as latent heat.

However, the heat dissipation apparatus has a problem in that pressure increases as temperature rises, because temperature and pressure are proportional to each other. When pressure increases due to high temperature conducted from a heat generating element within the sealed heat dissipation apparatus, it may cause the heat dissipation apparatus itself to rupture. To address this problem, it is necessary to prevent the pressure from increasing, and the heat dissipation apparatus requires a sufficient internal volume to allow pressure equilibrium to be achieved during the phase-change circulation process of a material.

In particular, it is most preferable for the phase change material to satisfy conditions in which it can undergo a phase change between a gas state and a liquid state within a narrow temperature range, is inexpensive and has little environmental impact, and water is a representative phase change material.

However, water is frozen into solid ice at 0°C or below, and it has been pointed out that, due to the physical property that its volume significantly increases upon freezing, there is a problem in that a component containing water as a refrigerant may be damaged.

### [Disclosure]

### [Technical Problem]

The present disclosure is proposed to resolve the aforementioned technical issues and is directed to providing an active heat dissipation apparatus that can improve heat dissipation performance of a heat generating device (e.g., an electronic device).

In addition, the present disclosure is directed to providing an active heat dissipation apparatus that can maximize the heat transport capability of a refrigerant filled therein.

Further, the present disclosure is directed to providing an active heat dissipation apparatus having excellent manufacturability.

Further, the present disclosure is directed to providing an active heat dissipation apparatus that enables low-cost product production by replacing with a metal material having low thermal conductivity, while exhibiting an effect equal to or greater than that of conventional heat dissipation performance.

Further, the present disclosure is directed to providing an active heat dissipation apparatus that not only allows water, which is low in cost and has little environmental impact, to be employed as a refrigerant, but also resolves the problem of component damage caused by an increase in volume upon freezing of the water.

Technical issues of the present disclosure are not limited to the above-mentioned technical issues, and other technical issues not mentioned above will be clearly understood by those skilled in the art from the following description.

### [Technical Solution]

An active heat dissipation apparatus according to an embodiment of the present disclosure includes a heat-conducting panel body having a refrigerant flow space in which a refrigerant is filled and flows, and a refrigerant damper disposed at a middle portion in a thickness direction of the refrigerant flow space and configured to elastically absorb volume expansion of the refrigerant after freezing within a limit that does not increase a separation distance between a first side surface and a second side surface of the refrigerant flow space when the refrigerant expands in volume due to freezing.

The refrigerant flow space may include a first refrigerant flow path provided in an evaporation region in which liquid refrigerant of the refrigerant is stored and the stored liquid refrigerant is phase-changed into a gas state by heat supplied from a heat dissipation housing body as a heat generating target, and a plurality of second refrigerant flow paths formed in a direction of gravity or inclined with respect to the direction of gravity toward the first refrigerant flow path and configured to guide the liquid refrigerant of the refrigerant, phase-changed from a gas state to a liquid state, to flow toward the first refrigerant flow path, and the refrigerant damper may be disposed on a side of the second refrigerant flow paths

The refrigerant damper may be disposed in a condensation region excluding the evaporation region.

The heat-conducting panel body may include a first-side heat-conducting panel forming the first side surface of the refrigerant flow space, and a second-side heat-conducting panel forming the second side surface of the refrigerant flow space, and the refrigerant damper may be fixed in the refrigerant flow space corresponding to a middle portion between the first-side heat-conducting panel and the second-side heat-conducting panel.

A first surface of the refrigerant damper may be disposed to have a predetermined separation distance from an inner surface of the first-side heat-conducting panel, and a second surface thereof may be disposed to have a predetermined separation distance from an inner surface of the second-side heat-conducting panel.

The heat-conducting panel body may further include a plurality of strength reinforcement portions protruding from the first-side heat-conducting panel and the second-side heat-conducting panel toward the refrigerant flow space, and the refrigerant damper may be fixed by the plurality of strength reinforcement portions that are in surface contact with each other within the refrigerant flow space.

The refrigerant damper may be provided with a plurality of through holes formed therethrough such that the plurality of strength reinforcement portions formed on the first-side heat-conducting panel and the second-side heat-conducting panel pass through the refrigerant damper and come into surface contact with each other within the refrigerant flow space.

When each of the plurality of strength reinforcement portions has a flat bonding surface of a predetermined diameter formed at a distal end thereof, the plurality of through holes formed in the refrigerant damper may be formed to have an inner diameter greater than the diameter of the bonding surfaces of the plurality of strength reinforcement portions.

The heat-conducting panel body may further include a plurality of inclined guides that protrude from the first-side heat-conducting panel and the second-side heat-conducting panel, respectively, toward the refrigerant flow space to a depth at which they do not come into surface contact with each other, and are inclined downward so as to guide condensed liquid refrigerant to flow toward a lower side inclined with respect to the direction of gravity, and the first surface of the refrigerant damper may be fixed in close contact with the inclined guides of the first-side heat-conducting panel, and the second surface thereof may be fixed in close contact with the inclined guides of the second-side heat-conducting panel.

The refrigerant damper may be formed of an elastic material that is deformable by an external force, and may have a thickness, in a state where no external force is applied, greater than a minimum separation distance between the inclined guides of the first-side heat-conducting panel and the inclined guides of the second-side heat-conducting panel.

An inner diameter of the plurality of through holes formed in the refrigerant damper may be formed to be of a size such that, when the first surface and the second surface of the refrigerant damper are fixed in close contact with inclined guides formed on the first and second surfaces of the first-side heat-conducting panel and the second-side heat-conducting panel, the through holes do not come into contact with distal ends of the plurality of strength reinforcement portions.

Some of the plurality of strength reinforcement portions may be configured such that, when a single metal panel member is bent and then bonded or when two metal panel members are bonded, they pass through the plurality of through holes formed in the refrigerant damper, come into surface contact, and are then bonded to each other by a welding method.

When the heat-conducting panel body is fixed to a press-fit portion formed on a rear surface of the heat dissipation housing body in a direction of gravity or inclined with respect to the direction of gravity, the refrigerant damper may be disposed at a relatively lower portion in the direction of gravity in the heat-conducting panel body.

The refrigerant damper may be made of an elastic material including a rubber material capable of elastically absorbing at least a volume expanded due to freezing of the refrigerant.

### [Advantageous Effects]

An active heat dissipation apparatus according to an embodiment of the present disclosure can achieve various advantages as follows.

First, it is advantageous in that heat concentration caused by an upward flow of heat at a rear surface of a heat dissipation housing body is minimized, and active heat transfer by a phase change of a refrigerant is enabled, thereby significantly improving overall heat dissipation performance.

Second, it is advantageous in that heat transport capability is maximized by shortening a vapor-liquid circulation cycle time of a refrigerant filled therein, thereby improving heat dissipation performance.

Third, it is advantageous in that a material of a heat-conducting panel body, which defines a refrigerant flow space in which a refrigerant flows while undergoing a phase change, is replaced with a SUS material, which is a metal material having lower thermal conductivity than an aluminum material, while achieving higher heat dissipation performance compared to that of a conventional structure made of the aluminum material.

Fourth, it is advantageous in that a refrigerant damper is provided in a lower portion in a gravity direction where a liquid refrigerant is mainly stored, thereby preventing product damage due to freezing in extremely cold seasons even when distilled water (water) is employed as a refrigerant filled in a heat-conducting panel body made of a SUS material.

### [Description of Drawings]

FIG. 1 is a perspective view illustrating an implementation of installation of an active heat dissipation apparatus, according to an embodiment of the present disclosure, on a rear portion of an antenna device.
FIG. 2 is an exploded perspective view of FIG. 1.
FIG. 3 is a developed view illustrating the active heat dissipation apparatus according to an embodiment of the present disclosure.
FIG. 4 is a process diagram illustrating a manufacturing process of the active heat dissipation apparatus according to an embodiment of the present disclosure based on a bending method of FIG. 3.
FIG. 5 is a plan view of the active heat dissipation apparatus according to an embodiment of the present disclosure, and is a transparent view showing the interior thereof.
FIG. 6 is a perspective view illustrating the interior of a refrigerant flow space in a state where a first-side heat-conducting panel of a heat-conducting panel body of FIG. 5 is removed.
FIG. 7 is a partially enlarged perspective view of FIG. 6.
FIG. 8 is a perspective view illustrating a refrigerant damper among components of FIG. 6.
FIG. 9 is a cross-sectional view taken along line A-A of FIG. 5, and a partially enlarged view thereof.

### <Description of reference numerals>

100: Antenna device 110: Heat dissipation housing body
200: Active heat dissipation apparatus
200-1: First-side heat-conducting panel
200-2: Second-side heat-conducting panel
201: Press-fit end
203: Heat dissipation plate portion
205: Refrigerant flow space
210: First refrigerant flow path
215: Inclined guide
220: Second refrigerant flow path
230: Third refrigerant flow path
240: Multiple strength reinforcement portions
250: Refrigerant damper
255: Through hole 300: Absorber
T: Arbitrary reference line

### [Mode for Invention]

Hereinafter, active heat dissipation apparatuses according to embodiments of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

In general, heat generating devices (electronic devices) are manufactured in various forms across a wide range of industries. However, since the applicant of the present disclosure is a company engaged in the manufacture of wireless communication equipment, and a representative heat generating device (electronic device) among such wireless communication equipment is an antenna device, the antenna device will be described below as a specific example.

However, the active heat dissipation apparatus according to embodiments of the present disclosure described below should not be construed as being limited only to application to the antenna device.

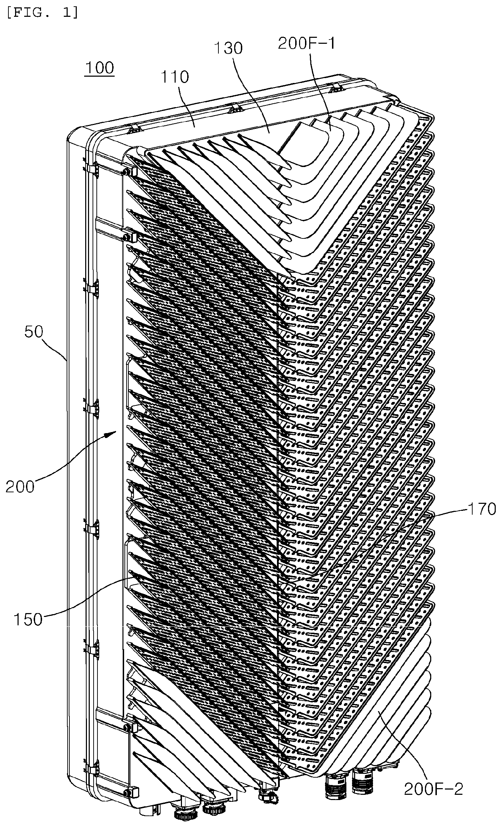

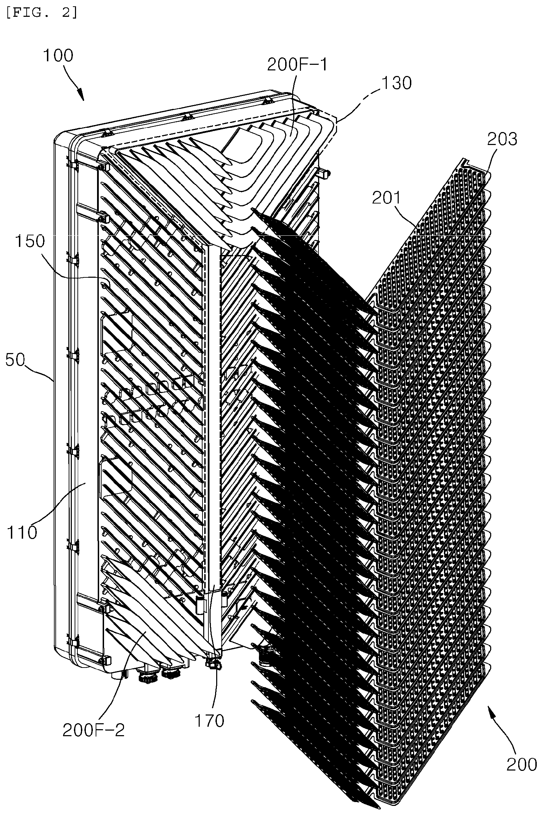

As shown in FIGS. 1 and 2, an antenna device 100 to which an active heat dissipation apparatus 200 according to embodiments of the present disclosure is applied includes a heat dissipation housing body 110 that defines an accommodation space opened toward a front and has a rectangular parallelepiped shape with a long and thin front-to-rear accommodation width in a substantially vertical direction.

The heat dissipation housing body 110 may be made of a thermally conductive material (particularly, a metallic material) so as to be in surface thermal contact with heat generating elements (not shown) and effectively transfer heat.

Inside the accommodation space of the heat dissipation housing body 110, although not shown in the drawings, a main board may be stacked and disposed, in which a plurality of Micro Bellows Filter (MBF) elements are mounted on a front surface via a clamshell as a substrate for a Power Amplifier Unit (PAU) and a Digital Transceiving Unit (DTU), and a kind of heat generating elements are mounted on a rear surface.

Here, the main board may include heat generating elements, which generate a large amount of heat during operation, such as RFIC elements or Power Amplifier (PA) elements. However, in the embodiments of the present disclosure, it should be noted that the electronic device is merely described by taking the antenna device as an example, and the heat generating elements are not limited to the above configuration. For example, typical heat generating elements such as semiconductors or a CPU of a PC may also be employed.

A radome panel 50 is installed on the front surface of the accommodation space of the heat dissipation housing body 110 to protect radiating elements implemented as antenna elements from the outside while allowing radiation from the radiating elements to be smoothly performed.

However, in the antenna device, which is the electronic device requiring a relatively high level of heat dissipation, the radome panel 50 that is not suitable for heat dissipation is installed on the front surface of the heat dissipation housing body 110 as described above, so that there is a greater need for concentrated heat dissipation through portions other than the front surface of the heat dissipation housing body 110, and an effective heat dissipation design using a limited heat dissipation area is required.

Meanwhile, the active heat dissipation apparatus 200 according to embodiments of the present disclosure may be installed on the rear surface of the heat dissipation housing body 110.

The active heat dissipation apparatus 200 according to embodiments of the present disclosure is provided in the form of a heat dissipation fin, and is characterized in that it is provided, more precisely, as a thin vapor chamber type filled with a refrigerant, which is a material capable of undergoing phase change by heat supplied from the outside, unlike fixed heat dissipation fins 200F-1 and 200F-2 to be described later.

Here, the active heat dissipation apparatus 200 according to embodiments of the present disclosure may include therein an absorber (not shown) that absorbs a liquid refrigerant of the refrigerant, retains it at a position close to the heat generating elements, and promotes evaporation of the liquid refrigerant into a vapor refrigerant.

The concept of retaining the liquid refrigerant by the absorber is not limited to simply absorbing and storing the liquid refrigerant, but should be understood as including moving at least the liquid refrigerant, by absorptive force (or capillary force), in a direction (upward) opposite to gravity to a position higher than a liquid level.

In general, the well-known (previously disclosed) vapor chamber typically includes a wick member having a wick structure in which a plurality of pores are formed. Here, the wick member may be manufactured in a form in which metal powder is sintered so as to form the plurality of pores that allow the liquid refrigerant filled inside a panel member made of a thermally conductive material to move toward a side where heat generating elements are provided by capillary force, while the vapor refrigerant may freely flow to the outside.

However, the wick member is not limited to the above-described sintered metal wick member, and may be defined as a concept encompassing any possible material, including fibrous materials, regardless of its designation such as the absorber, as long as it can absorb and disperse the liquid refrigerant or promote vaporization thereof.

As shown in FIGS. 1 and 2, a trench structure 170 having an empty portion that vertically divides a central region between a left end and a right end may be provided on the rear surface of the heat dissipation housing body 110.

Here, on the rear surface of the heat dissipation housing body 110 corresponding to left and right sides of the trench structure 170, a plurality of press-fit portions 150 may be provided so that a plurality of active heat dissipation apparatuses 200 according to an embodiment of the present disclosure are arranged to be inclined upward toward the left end and the right end, respectively. That is, the press-fit portions 150 are provided to be inclined upward to the left and to the right with respect to the trench structure 170, so that a pair of active heat dissipation apparatuses 200 fixed thereto may form a 'V'-shaped configuration while a plurality of heat dissipation apparatuses being arranged in a pattern in a vertical direction.

Meanwhile, the active heat dissipation apparatuses 200 according to an embodiment of the present disclosure are provided in plural and are all formed in the same rectangular shape with identical specifications, each being elongated in the same longitudinal direction. As shown in FIGS. 1 and 2, when the active heat dissipation apparatuses 200 of identical specifications are installed in the plurality of press-fit portions 150, one inverted triangular region at an upper portion of the rear surface of the heat dissipation housing body 110 and two right triangular regions at lower left and right portions of the rear surface of the heat dissipation housing body 110 are not occupied by the active heat dissipation apparatuses 200, and the fixed heat dissipation fins 200F-1 and 200F-2 may be disposed therein.

Here, as shown in FIG. 2, the fixed heat dissipation fins 200F-1 and 200F-2 may include upper fixed heat dissipation fins 200F-1 disposed on the upper portion of the rear surface of the heat dissipation housing body 110, which is not occupied by the active heat dissipation apparatuses 200 according to an embodiment of the present disclosure, and lower fixed heat dissipation fins 200F-2 disposed on the lower left and right portions of the rear surface of the heat dissipation housing body 110, which are not occupied by the active heat dissipation apparatuses 200 according to embodiments of the present disclosure.

Unlike the active heat dissipation apparatus 200 according to embodiments of the present disclosure, such fixed heat dissipation fins 200F-1 and 200F-2 are provided in the form of general heat sink fins that do not contain a refrigerant therein, and may be fabricated from a metal material having high thermal conductivity, such as an aluminum material or an aluminum alloy material.

In the first installation implementation, a heat transfer medium (not shown) formed in a general vapor chamber type may be provided in a region where the trench structure 170 is formed on the rear surface of the heat dissipation housing body 110 and in a region (an inverted triangular region 130) where the upper fixed heat dissipation fins 200F-1 among the fixed heat dissipation fins 200F-1 and 200F-2 are installed.

Meanwhile, as shown in FIG. 2, the press-fit portions 150 may be formed on the rear surface of the heat dissipation housing body 110 to allow press-fit installation of the plurality of active heat dissipation apparatuses 200 according to an embodiment of the present disclosure.

In this case, although not shown in the drawings, it is preferable that the active heat dissipation apparatuses are press-fitted into the press-fit portions 150 after being treated with a thermal epoxy in order to improve heat transfer efficiency.

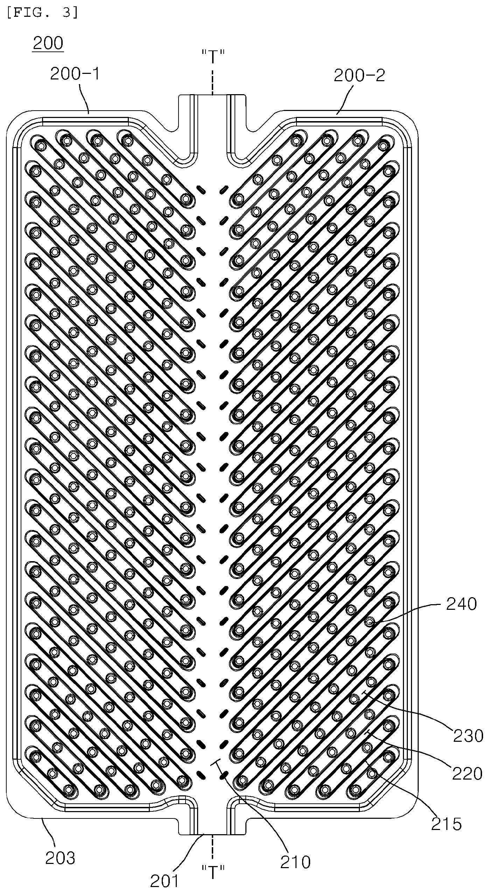

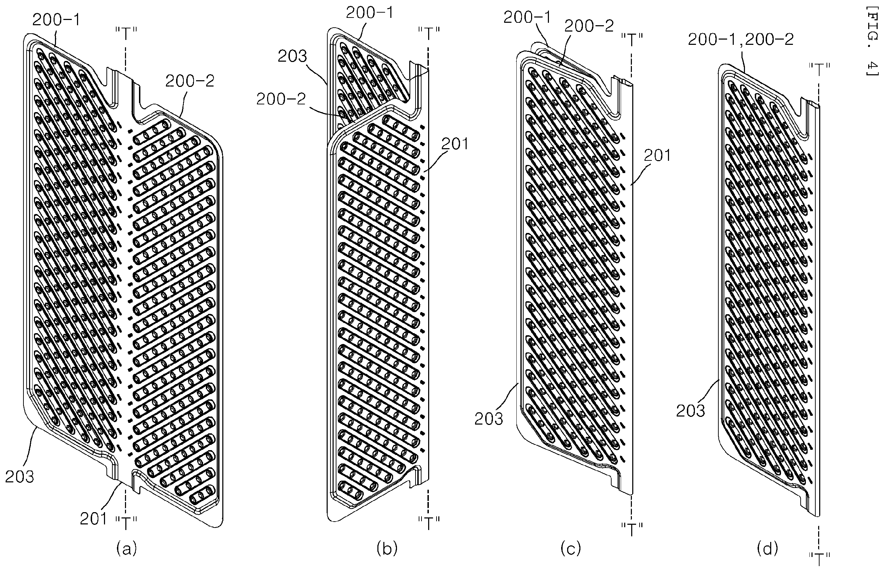

FIG. 3 is a developed view illustrating the active heat dissipation apparatus according to an embodiment of the present disclosure, and FIG. 4 is a process diagram illustrating a manufacturing process of the active heat dissipation apparatus according to an embodiment of the present disclosure based on a bending method of FIG. 3.

As shown in FIGS. 3 and 4, the active heat dissipation apparatus 200 according to an embodiment of the present disclosure includes, as a single metal panel member, heat-conducting panel bodies 200-1 and 200-2 having a refrigerant flow space in which the refrigerant is filled and flows therein, formed through a bonding process after bending.

That is, the active heat dissipation apparatus 200 according to an embodiment of the present disclosure may be manufactured such that a sealed refrigerant flow space 205 is formed therein by bending the heat-conducting panel bodies 200-1 and 200-2, which are the single metal panel member, with respect to a predetermined arbitrary reference line T shown in FIG. 4 and then bonding them.

Here, the heat-conducting panel bodies 200-1 and 200-2, as the single metal panel member, may define the refrigerant flow space 205 by a predetermined method. In particular, the active heat dissipation apparatus 200 according to an embodiment of the present disclosure may directly form at least a first refrigerant flow path 210, which will be described later, in the refrigerant flow space 205 in which the refrigerant is filled and flows, through the bending and bonding processes among predetermined methods.

Here, the refrigerant flow space 205 may include the first refrigerant flow path 210, which is provided in a portion relatively located on the lower side in the direction of gravity to facilitate collection (retention) or storage of liquid refrigerant and forms an evaporation region for phase-changing the liquid refrigerant into vapor refrigerant, and a second refrigerant flow path 220, which is provided in a condensation region that is a portion other than the first refrigerant flow path 210 and guides the flow of the liquid refrigerant phase-changed from the vapor refrigerant to the above-described evaporation region.

That is, when the portion in which the first refrigerant flow path 210 is provided, formed through the bending, is defined as the evaporation region where the liquid refrigerant of the refrigerant is evaporated, and a remaining portion other than the evaporation region is defined as the condensation region, the second refrigerant flow path 220 may be provided in the condensation region.

In particular, the first refrigerant flow path 210 is a portion shape-modified by bending among the predetermined methods applied to the single metal panel member, and is formed such that the liquid refrigerant of the refrigerant is filled with only a separation distance corresponding to the material thickness of the metal panel member with respect to the heat generating elements or the press-fit portions 150 in which the heat generating elements are provided.

In this case, the first refrigerant flow path 210 serves as a portion in which the liquid refrigerant of the refrigerant filled in the refrigerant flow space 205 is stored and retained, and may be arranged vertically in the direction of gravity or arranged such that at least an upper end and a lower end thereof are inclined with respect to the direction of gravity. Thus, the liquid refrigerant stored in the first refrigerant flow path 210 has a liquid level positioned at least at a portion closer to the lower end among the above-described inclined upper and lower ends.

However, the first refrigerant flow path 210 is not a concept that is physically completely separated (partitioned) from the condensation region in which the plurality of second refrigerant flow paths 220 are formed. Even when defined as the first refrigerant flow path 210, as described above, a portion located below the liquid level of the refrigerant is filled with the refrigerant, but a portion of the first refrigerant flow path 210 located above the liquid level may also exist, and a configuration such as the above-described absorber may be required to raise the stored refrigerant to the first refrigerant flow path 210 located above the liquid level.

Meanwhile, the active heat dissipation apparatus 200 according to an embodiment of the present disclosure may be manufactured such that the sealed refrigerant flow space 205 is formed therein by bending the single heat-conducting panel body 200-1 and 200-2 with respect to the predetermined arbitrary reference line T (see FIG. 4 in detail) to be described later, and then bonding it.

Therefore, the first refrigerant flow path 210 may be defined as a refrigerant filling and flow space in which the liquid refrigerant of the refrigerant is filled, the space being a portion shape-modified by the bending and spaced apart from the heat generating elements or the press-fit portion 150 in which the heat generating elements are provided by only a separation distance corresponding to the material thickness of the metal panel member.

However, the manufacturing method of the active heat dissipation apparatus according to the present disclosure is not limited to manufacturing the single metal panel member by the bending method as described above, and it is also possible to manufacture the apparatus by directly bonding two metal panel members without the bending process.

Meanwhile, the plurality of second refrigerant flow paths 220 are formed in the condensation region excluding the first refrigerant flow path 210, and may serve as flow paths through which liquid refrigerant, condensed from a gas state to a liquid state, flows from the other end in the width direction of the heat-conducting panel bodies 200-1 and 200-2 toward the first refrigerant flow path 210 by surface tension or gravity.

More specifically, the second refrigerant flow path 220 provides a flow path such that, when a refrigerant in a gas state (vapor refrigerant) is agglomerated into a refrigerant in a liquid state (liquid refrigerant) through a heat exchange process with outdoor air in the condensation region, the volume thereof gradually increases at a position in the refrigerant flow space 205 where agglomeration occurs, and, when flowing downward in the direction of gravity, a uniform amount of liquid refrigerant flows down and is supplied toward the first refrigerant flow path 210.

In particular, as will be described later, the second refrigerant flow path 220 may be defined between a plurality of inclined guides 215, and when the liquid refrigerant agglomerated in the condensation region flows downward toward the first refrigerant flow path 210, dispersed flow toward second refrigerant flow paths 220 adjacent to its own flow path, i.e., the second refrigerant flow path 220 may be suppressed by surface tension.

That is, since the plurality of inclined guides 215 have a narrower flow space than the second refrigerant flow paths 220, surface tension acts to suppress flow toward adjacent second refrigerant flow paths 220.

As such, when the dispersed flow of the condensed liquid refrigerant is suppressed by the plurality of inclined guides 215 and the second refrigerant flow paths 220, the vertical downward falling of the liquid refrigerant in the direction of gravity can be minimized. The liquid refrigerant agglomerated in the condensation region can be supplied in a uniform amount toward the first refrigerant flow path 210 without being biased, by respective lower ends that are connected to the first refrigerant flow path 210 at uniform intervals.

In addition, the plurality of second refrigerant flow paths 220 may be defined between the plurality of inclined guides 215 that are formed to protrude from opposing surfaces of the heat-conducting panel bodies 200-1 and 200-2 into the refrigerant flow space 205.

Referring to FIG. 4(a), the active heat dissipation apparatus 200 according to an embodiment of the present disclosure may simultaneously form the above-described first refrigerant flow path 210, second refrigerant flow paths 220, and the plurality of inclined guides 215 for implementing them, which will be described later, through the press process before bending the heat-conducting panel bodies 200-1 and 200-2 formed of the single member of a predetermined thermally conductive material.

At this time, when the heat-conducting panel bodies 200-1 and 200-2 in a flat unfolded state before the bending process are formed in a rectangular shape having a width in the horizontal direction smaller than a length in the vertical direction as shown in FIG. 4, the arbitrary reference line T may be disposed to vertically pass through a central portion between the left end and the right end and may serve as a reference for bending. In this case, the central portion between the left end and the right end of the heat-conducting panel bodies 200-1 and 200-2 may be understood as a middle portion that becomes a boundary between a first-side heat-conducting panel 200-1 and a second-side heat-conducting panel 200-2.

Referring to FIGS. 4(b) and 4(c), the first-side heat-conducting panel 200-1 corresponding to the left side and the second-side heat-conducting panel 200-2 corresponding to the right side with respect to the arbitrary reference line T may be bent, using a bending jig (not shown) or the like, so as to come into contact with each other.

At this time, not only the first refrigerant flow path 210 and the second refrigerant flow paths 220, but also a third refrigerant flow path 230 additionally formed according to an embodiment may be provided. In addition, a plurality of strength reinforcement portions 240 required for bonding may be formed to face each other in surface contact.

Referring to FIG. 4(d), when the first-side heat-conducting panel 200-1 and the second-side heat-conducting panel 200-2 of the heat-conducting panel bodies 200-1 and 200-2 come into surface contact with each other, they may be bonded to each other along their peripheral edges using a predetermined bonding method, and at the same time, the plurality of strength reinforcement portions 240 in surface contact may also be bonded to each other using a predetermined bonding method.

At this time, one end and the other end of the first refrigerant flow path 210, formed through the bending process, may be formed to allow the refrigerant flow space 205 to communicate with the outside for a refrigerant filling process and a caulking process to be described later, while the remaining portion (heat dissipation plate portion 203) may be hermetically coupled so that the refrigerant flow space 205 is completely sealed from the outside.

More specifically, as shown in FIG. 4, the active heat dissipation apparatus 200 according to an embodiment of the present disclosure includes, with respect to the arbitrary reference line T defined in a straight line in the vertical direction, the first-side heat-conducting panel 200-1 forming the left end before bending and the second-side heat-conducting panel 200-2 forming the right end before bending, as the heat-conducting panel bodies 200-1 and 200-2. Here, the first-side heat-conducting panel 200-1 and the second-side heat-conducting panel 200-2 may be understood as defining the heat-conducting panel bodies 200-1 and 200-2 prior to the bending process.

For example, the heat-conducting panel bodies 200-1 and 200-2, formed through bending and bonding, may be defined as including the press-fit end 201 that is press-fitted into each of the press-fit portions 150 which are formed to be inclined upward to the left and right about the trench structure 170 formed on the rear surface of the heat dissipation housing body 110 as a heat dissipation target, and the heat dissipation plate portion 203 that is a region defined by the peripheral edges of the heat-conducting panel bodies 200-1 and 200-2 excluding the press-fit end 201 and performs heat dissipation through phase change of the refrigerant and heat exchange with external air (outdoor air).

That is, the heat dissipation plate portion 203 is preferably defined as all regions, excluding the above-described press-fit end 201, that perform heat dissipation after heat exchange between the refrigerant (in particular, vapor refrigerant) filled therein and external air (outdoor air). Heat exchange between the vapor refrigerant within the heat dissipation plate portion 203 and the outdoor air means that the vapor refrigerant is condensed and undergoes the phase change into liquid refrigerant.

Meanwhile, in the heat dissipation plate portion 203, the plurality of strength reinforcement portions 240 may be formed to protrude into the refrigerant flow space 205 from an inner surface of the first-side heat-conducting panel 200-1 and an inner surface of the second-side heat-conducting panel 200-2, which are spaced apart in a thickness direction.

In addition, as will be described later, the plurality of strength reinforcement portions 240 may be simultaneously formed through the press process together with the second refrigerant flow paths 220, the third refrigerant flow path 230, and the plurality of inclined guides 215, so that, when observed from the outside after bonding, they may be understood as being recessed from the exterior of the heat dissipation plate portion 203 toward the interior.

The first refrigerant flow path 210 may be defined as a flow path that is positioned on the lower side with respect to the direction of gravity and, when the refrigerant that has undergone phase change into a liquid state (liquid refrigerant) in the refrigerant flow space 205 flows downward along the direction of gravity, collects the refrigerant on the same inclined guide 215 and, at the same time, uniformly transports and distributes the liquid refrigerant over an entire evaporation region where it is changed into a vapor state by heat transferred from the heat generating elements of the heat dissipation housing body 110. In this case, the function of uniformly transporting and distributing the liquid refrigerant in the first refrigerant flow path 210 may refer to a concept of transporting the liquid refrigerant in a direction different from the direction of gravity, at least by the absorber to be described later.

Further, the function of uniformly transporting and distributing the liquid refrigerant in the first refrigerant flow path 210 may be understood as a concept in which the liquid refrigerant is uniformly supplied and transported by the plurality of second refrigerant flow paths 220 or the plurality of inclined guides 215 formed at an inclination with respect to the single first refrigerant flow path 210.

The absorber to be described later may be inserted and installed inside the first refrigerant flow path 210, thereby promoting the collection and distribution of the liquid refrigerant described above, as well as its transport in the direction different from the direction of gravity.

Here, the first refrigerant flow path 210 may be formed symmetrically with respect to the arbitrary reference line T in a thickness direction of the refrigerant flow space 205, as shown in FIG. 4 after bending.

Among metal materials forming the heat-conducting panel bodies 200-1 and 200-2, which serves as a substantial medium for transferring heat generated from the heat generating elements to the refrigerant filled in the refrigerant flow space 205, aluminum is the material most widely employed in the current industrial field.

As is well known, aluminum (Al) has a thermal conductivity of approximately 230 W/m·K and a low specific gravity of 2.7, and thus is one of the most widely used materials for heat dissipation elements.

However, although aluminum has excellent thermal conductivity and specific gravity, it has disadvantages in that it is relatively expensive in terms of cost-effectiveness and the types of refrigerants filled therein are limited. In particular, when the refrigerant is distilled water (water), aluminum may undergo a certain chemical reaction with the contacting water to generate hydrogen compounds within the closed refrigerant flow space 205, thereby increasing internal pressure. Thus, the distilled water (water), which is inexpensive and environmentally harmless among available refrigerants, should be excluded.

Hereinafter, in the active heat dissipation apparatus 200 according to an embodiment of the present disclosure, in order to solve the problems of increased cost and the exclusion of distilled water (water), which arise when aluminum is selected as the material of the heat-conducting panel bodies 200-1 and 200-2 as described above, SUS (stainless steel), which exhibits minimal chemical reactivity upon contact with distilled water (water) as a usable refrigerant and has a relatively low manufacturing cost, is adopted. The following description is provided on the premise that thermal conductivity (heat dissipation performance) corresponding to that of adopted aluminum can be secured.

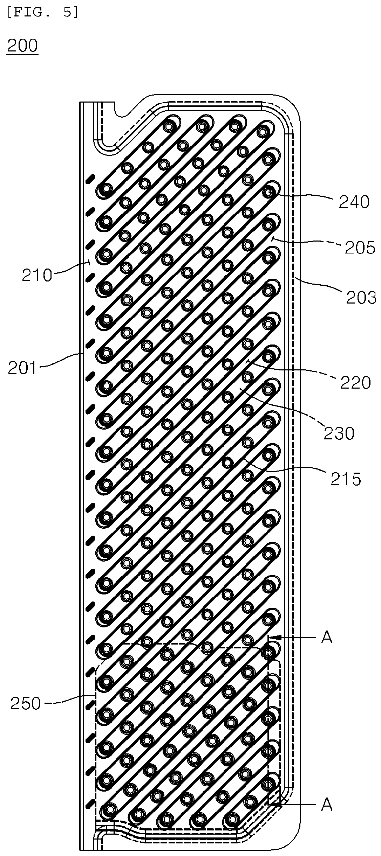

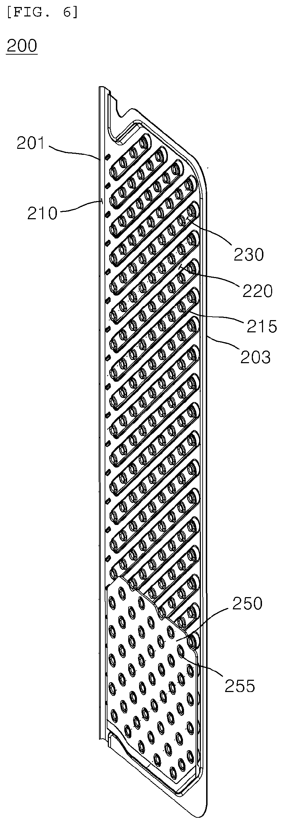

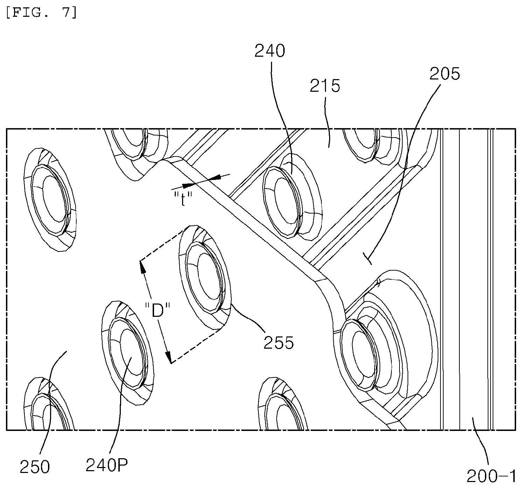

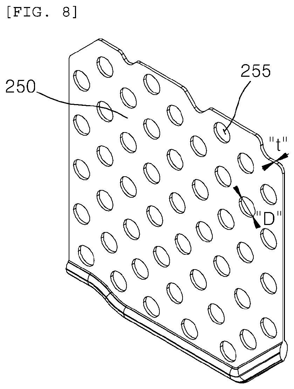

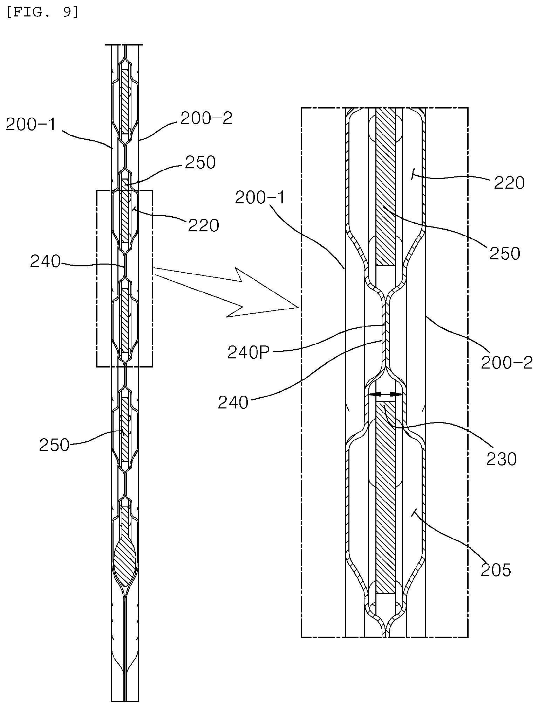

FIG. 5 is a plan view of the active heat dissipation apparatus according to an embodiment of the present disclosure, and is a transparent view showing the interior thereof, FIG. 6 is a perspective view illustrating the interior of the refrigerant flow space in a state where the first-side heat-conducting panel of the heat-conducting panel body of FIG. 5 is removed, FIG. 7 is a partially enlarged perspective view of FIG. 6, FIG. 8 is a perspective view illustrating a refrigerant damper among components of FIG. 6, and FIG. 9 is a cross-sectional view taken along line A-A of FIG. 5, and a partially enlarged view thereof.

Hereinafter, the refrigerant will be described as being limited to distilled water (water), and the description will be based on the phase change characteristics of water under natural conditions.

In the active heat dissipation apparatus 200 according to an embodiment of the present disclosure, the refrigerant filled in the refrigerant flow space 205 is distilled water (water), and may be filled to a level such that, in consideration of volume change during phase change, a liquid level in a liquid refrigerant state is formed at a relatively lower portion in the direction of gravity.

For example, since the volume of the refrigerant increases significantly when it undergoes a phase change from a liquid state to a vapor state, a small amount of liquid refrigerant is filled in advance in consideration thereof.

Meanwhile, in the case of the active heat dissipation apparatus 200 according to an embodiment of the present disclosure, only a phase change of the refrigerant from a liquid state to a gas state by evaporation and from a gas state to a liquid state by condensation is contemplated. However, when the antenna device is not in operation or during extremely cold conditions in which the external temperature drops sharply, there is a risk that the liquid refrigerant may freeze within the sealed refrigerant flow space 205.

In particular, as in the active heat dissipation apparatus 200 according to an embodiment of the present disclosure, when the material of the heat-conducting panel bodies 200-1 and 200-2 is formed of SUS and the refrigerant filled therein is water, there may arise a problem in that the liquid refrigerant can easily freeze at sub-zero temperatures, which correspond to the freezing point of water.

Freezing of the liquid refrigerant within the sealed refrigerant flow space 205 typically begins from the inner surface of the first-side heat-conducting panel 200-1 and the inner surface of the second-side heat-conducting panel 200-2, which are substantially in contact with external air (outdoor air), toward the central portion of the refrigerant flow space 205. Since the volume expansion ratio of water upon freezing reaches 10%, such expansion may weaken the bonding strength of the plurality of strength reinforcement portions 240 and, in some cases, may lead to damage of the product itself.

In order to prevent product damage caused by freezing of the refrigerant as described above, as shown in FIGS. 5 to 9, the active heat dissipation apparatus 200 according to an embodiment of the present disclosure may further include a refrigerant damper 250, which is disposed at a middle portion in a thickness direction of the refrigerant flow space 205 and elastically absorbs volume expansion of the refrigerant after freezing, within a limit that does not increase a separation distance between one side surface and the other side surface of the refrigerant flow space 205, during volume expansion due to the freezing of the refrigerant.

Here, the refrigerant damper 250 may be fixed in the refrigerant flow space 205 corresponding to a middle portion between the first-side heat-conducting panel 200-1 and the second-side heat-conducting panel 200-2.

At this time, as shown in FIG. 9, one surface of the refrigerant damper 250 may be disposed to have a predetermined separation distance from the inner surface of the first-side heat-conducting panel 200-1, and the other surface thereof may be disposed to have a predetermined separation distance from the inner surface of the second-side heat-conducting panel 200-2.

The separation distance between one surface of the refrigerant damper 250 and the inner surface of the first-side heat-conducting panel 200-1, and the separation distance between the other surface of the refrigerant damper 250 and the inner surface of the second-side heat-conducting panel 200-2, may serve as spaces through which vapor refrigerant (water vapor) evaporated from the first refrigerant flow path 210 corresponding to the evaporation region diffuses and flows within the condensation region in which the refrigerant damper 250 is disposed.

Therefore, the refrigerant damper 250 may be limited to being disposed in the condensation region excluding the evaporation region in which the first refrigerant flow path 210 is formed, so that evaporation of the refrigerant on the side of the first refrigerant flow path 210 is not hindered.

Meanwhile, the refrigerant damper 250 may be fixed by the plurality of strength reinforcement portions 240 provided to be in surface contact with each other within the refrigerant flow space 205.

More specifically, as shown in FIG. 7, the plurality of strength reinforcement portions 240 protrude from the inner surfaces of the first-side heat-conducting panel 200-1 and the second-side heat-conducting panel 200-2 toward the refrigerant flow space 205, and are formed such that a flat bonding surface 240P having a predetermined diameter is provided at a distal end thereof, and the bonding surfaces 240P of the respective distal ends are bonded within the refrigerant flow space 205 by a bonding method such as welding.

Here, the refrigerant damper 250 may be provided with a plurality of through holes 255 formed therethrough such that the plurality of strength reinforcement portions 240 formed on the first-side heat-conducting panel 200-1 and the second-side heat-conducting panel 200-2 pass through the refrigerant damper and come into surface contact with each other within the refrigerant flow space 205.

In this case, as shown in FIG. 7, the plurality of through holes 255 formed in the refrigerant damper 250 may be formed to have an inner diameter D greater than a diameter of the bonding surfaces 240P of the plurality of strength reinforcement portions 240.

Meanwhile, in the heat-conducting panel bodies 200-1 and 200-2, as described above, the plurality of inclined guides 215 may be further formed to protrude from the first-side heat-conducting panel 200-1 and the second-side heat-conducting panel 200-2 toward the refrigerant flow space 205 to a depth at which they do not come into surface contact with each other, and to be inclined downward so as to guide the flow of the condensed liquid refrigerant toward a lower side inclined with respect to the direction of gravity.

Here, one surface of the refrigerant damper 250 may be fixed in close contact with the inclined guides 215 of the first-side heat-conducting panel 200-1, and the other surface of the refrigerant damper 250 may be fixed in close contact with the inclined guides 215 of the second-side heat-conducting panel 200-2.

That is, when the refrigerant damper 250 is installed in the refrigerant flow space 205 between the first-side heat-conducting panel 200-1 and the second-side heat-conducting panel 200-2, it is fixed by the plurality of strength reinforcement portions 240 through mutual bonding with the plurality of strength reinforcement portions 240 passing through the plurality of through holes 255, and at the same time, one surface and the other surface thereof are fixed in close contact by the plurality of inclined guides 215 formed to protrude from the first-side heat-conducting panel 200-1 and the second-side heat-conducting panel 200-2 toward the refrigerant flow space 205, respectively, so that the refrigerant damper can be stably fixed without being displaced by external forces or internal pressure changes caused by phase change of the refrigerant.

Here, assuming that the refrigerant damper 250 is made of an elastic material that is deformable by an external force, as will be described later, a thickness t thereof in a state where no external force is applied may be formed to be greater than a minimum separation distance between the inclined guides 215 of the first-side heat-conducting panel 200-1 and the inclined guides 215 of the second-side heat-conducting panel 200-2.

This is to ensure that, when the refrigerant flow space 205 is formed by bonding the respective peripheral edges of the first-side heat-conducting panel 200-1 and the second-side heat-conducting panel 200-2, the refrigerant damper 250 is stably fixed through shape deformation caused by compression between the inclined guides 215 of the first-side heat-conducting panel 200-1 and those of the second-side heat-conducting panel 200-2.

However, among the plurality of strength reinforcement portions 240, some (strength reinforcement portions 240 disposed at a lower portion in the direction of gravity to be described later) may, when the single metal panel member is bent and then bonded or when two metal panel members are bonded, pass through the plurality of through holes 255 formed in the refrigerant damper 250, come into surface contact, and then have their bonding surfaces 240P bonded to each other by a welding method.

Since the welding heat at this time may affect the refrigerant damper 250, it is preferable that the inner diameter D of the plurality of through holes 255 formed in the refrigerant damper 250 be sized such that, as shown in FIG. 7, when one surface and the other surface of the refrigerant damper 250 are fixed in close contact with the inclined guides 215 formed on one and the other surfaces of the first-side heat-conducting panel 200-1 and the second-side heat-conducting panel 200-2, the through holes do not come into contact with the distal ends (including the peripheries of the bonding surfaces 240P) of the plurality of strength reinforcement portions 240.

In particular, the refrigerant damper 250 may be disposed at a relatively lower portion in the direction of gravity within the refrigerant flow space 205 of the heat-conducting panel bodies 200-1 and 200-2, when the heat-conducting panel bodies 200-1 and 200-2 are fixed to the press-fit portions 150 formed on the rear surface of the heat dissipation housing body 110 in the direction of gravity or inclined with respect to the direction of gravity. This is because, as described above, the proportion of the liquid refrigerant occupies only a part of the total volume of the refrigerant flow space in consideration of the above-described phase change, and the liquid refrigerant is stored at the lower portion in the direction of gravity.

The above-described refrigerant damper 250 may be made of an elastic material including a rubber material capable of elastically absorbing the expanded volume at least when the refrigerant undergoes volume expansion due to freezing.

As such, the active heat dissipation apparatus 200 according to an embodiment of the present disclosure provides an advantage in that, by fixing and installing the refrigerant damper 250 at a lower portion in the direction of gravity within the refrigerant flow space 205 where the liquid refrigerant is mainly stored, it actively absorbs the volume expansion of the refrigerant, which is provided as distilled water (water), upon freezing, thereby preventing damage to the product.

In addition, by enabling the refrigerant damper 250 to be stably fixed without displacement (shaking) due to internal pressure changes within the refrigerant flow space 205 during the phase change of the refrigerant or external forces such as any vibrations transmitted from the outside, an advantage of improving the durability of the product can be achieved.

As described above, an active heat dissipation apparatus according to an embodiment of the present disclosure has been described in detail with reference to the accompanying drawings. However, embodiments of the present disclosure are not necessarily limited to the above-described embodiment, and it will be apparent that various modifications and equivalent implementations are possible by those skilled in the art. Therefore, the true scope of the present disclosure is defined by the claims set forth below.

## Claims

1. An active heat dissipation apparatus comprising:
a heat-conducting panel body having a refrigerant flow space in which a refrigerant is filled and flows; and
a refrigerant damper disposed at a middle portion in a thickness direction of the refrigerant flow space and configured to elastically absorb volume expansion of the refrigerant after freezing within a limit that does not increase a separation distance between a first side surface and a second side surface of the refrigerant flow space when the refrigerant expands in volume due to freezing.

2. The active heat dissipation apparatus of claim 1,
wherein the refrigerant flow space comprises:
a first refrigerant flow path provided in an evaporation region in which liquid refrigerant of the refrigerant is stored and the stored liquid refrigerant is phase-changed into a gas state by heat supplied from a heat dissipation housing body as a heat generating target; and
a plurality of second refrigerant flow paths formed in a direction of gravity or inclined with respect to the direction of gravity toward the first refrigerant flow path and configured to guide the liquid refrigerant of the refrigerant, phase-changed from a gas state to a liquid state, to flow toward the first refrigerant flow path,
wherein the refrigerant damper is disposed on a side of the second refrigerant flow paths

3. The active heat dissipation apparatus of claim 2, wherein the refrigerant damper is disposed in a condensation region excluding the evaporation region.

4. The active heat dissipation apparatus of claim 1,
wherein the heat-conducting panel body comprises:
a first-side heat-conducting panel forming the first side surface of the refrigerant flow space; and
a second-side heat-conducting panel forming the second side surface of the refrigerant flow space,
wherein the refrigerant damper is fixed in the refrigerant flow space corresponding to a middle portion between the first-side heat-conducting panel and the second-side heat-conducting panel.

5. The active heat dissipation apparatus of claim 4, wherein a first surface of the refrigerant damper is disposed to have a predetermined separation distance from an inner surface of the first-side heat-conducting panel, and a second surface thereof is disposed to have a predetermined separation distance from an inner surface of the second-side heat-conducting panel.

6. The active heat dissipation apparatus of claim 4,
wherein the heat-conducting panel body further comprises a plurality of strength reinforcement portions protruding from the first-side heat-conducting panel and the second-side heat-conducting panel toward the refrigerant flow space, and
wherein the refrigerant damper is fixed by the plurality of strength reinforcement portions that are in surface contact with each other within the refrigerant flow space.

7. The active heat dissipation apparatus of claim 6, wherein the refrigerant damper is provided with a plurality of through holes formed therethrough such that the plurality of strength reinforcement portions formed on the first-side heat-conducting panel and the second-side heat-conducting panel pass through the refrigerant damper and come into surface contact with each other within the refrigerant flow space.

8. The active heat dissipation apparatus of claim 7, wherein, when each of the plurality of strength reinforcement portions has a flat bonding surface of a predetermined diameter formed at a distal end thereof, the plurality of through holes formed in the refrigerant damper are formed to have an inner diameter greater than the diameter of the bonding surfaces of the plurality of strength reinforcement portions.

9. The active heat dissipation apparatus of claim 7,
wherein the heat-conducting panel body further comprises a plurality of inclined guides that protrude from the first-side heat-conducting panel and the second-side heat-conducting panel, respectively, toward the refrigerant flow space to a depth at which they do not come into surface contact with each other, and are inclined downward so as to guide condensed liquid refrigerant to flow toward a lower side inclined with respect to the direction of gravity, and
wherein the first surface of the refrigerant damper is fixed in close contact with the inclined guides of the first-side heat-conducting panel, and the second surface thereof is fixed in close contact with the inclined guides of the second-side heat-conducting panel.

10. The active heat dissipation apparatus of claim 9, wherein the refrigerant damper is formed of an elastic material that is deformable by an external force, and has a thickness, in a state where no external force is applied, greater than a minimum separation distance between the inclined guides of the first-side heat-conducting panel and the inclined guides of the second-side heat-conducting panel.

11. The active heat dissipation apparatus of claim 9, wherein an inner diameter of the plurality of through holes formed in the refrigerant damper is formed to be of a size such that, when the first surface and the second surface of the refrigerant damper are fixed in close contact with inclined guides formed on the first and second surfaces of the first-side heat-conducting panel and the second-side heat-conducting panel, the through holes do not come into contact with distal ends of the plurality of strength reinforcement portions.

12. The active heat dissipation apparatus of claim 7, wherein some of the plurality of strength reinforcement portions are configured such that, when a single metal panel member is bent and then bonded or when two metal panel members are bonded, they pass through the plurality of through holes formed in the refrigerant damper, come into surface contact, and are then bonded to each other by a welding method.

13. The active heat dissipation apparatus of claim 2, wherein, when the heat-conducting panel body is fixed to a press-fit portion formed on a rear surface of the heat dissipation housing body in a direction of gravity or inclined with respect to the direction of gravity, the refrigerant damper is disposed at a relatively lower portion in the direction of gravity in the heat-conducting panel body.

14. The active heat dissipation apparatus of claim 1, wherein the refrigerant damper is made of an elastic material including a rubber material capable of elastically absorbing at least a volume expanded due to freezing of the refrigerant.
